(19) Europäisches Patentamt
European Patent Office
Office européen des brevets

(11) **EP 2 853 574 A1**

(12) **EUROPEAN PATENT APPLICATION**
published in accordance with Art. 153(4) EPC

(43) Date of publication:
01.04.2015 Bulletin 2015/14

(51) Int Cl.:
*C09K 3/10* (2006.01)          *B32B 27/00* (2006.01)
*B32B 27/20* (2006.01)         *C08J 5/18* (2006.01)
*C08J 9/32* (2006.01)          *C08K 7/22* (2006.01)
*C08L 83/05* (2006.01)         *C08L 83/07* (2006.01)
*H01L 31/042* (2014.01)

(21) Application number: 13793058.2

(22) Date of filing: 22.05.2013

(86) International application number:
PCT/JP2013/064216

(87) International publication number:
WO 2013/176179 (28.11.2013 Gazette 2013/48)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 22.05.2012   JP 2012116335
19.03.2013   JP 2013056853

(71) Applicant: Sekisui Chemical Co., Ltd.
Osaka 530-8565 (JP)

(72) Inventors:
• GOTOH, Masahiko
Mishima-gun
Osaka 618-0021 (JP)
• NAKAMURA, Kouzou
Mishima-gun
Osaka 618-0021 (JP)
• NAKATA, Yasushi
Mishima-gun
Osaka 618-0021 (JP)

(74) Representative: Ter Meer Steinmeister & Partner
Patentanwälte mbB
Mauerkircherstrasse 45
81679 München (DE)

(54) **SHEET-SHAPED SEAL MEMBER, AND LAYERED SHEET-SHAPED SEAL MEMBER**

(57) There is provided a sheet-shaped sealing material that has excellent shock absorbency, sealing properties, cold and heat resistance, and light resistance even if the thickness is small. The sheet-shaped sealing material according to the present invention comprises: a silicone resin (A); and a plurality of particles (B) dispersed in the silicone resin and each having a cavity portion therein. The thickness of the sheet-shaped sealing material is, for example, 0.05 to 4 mm. The plurality of particles (B) comprise, for example, foamed particles that is thermally expanded.

## Fig. 1

**Description**

Technical Field

The present invention relates to a sheet-shaped sealing material and a layered sheet-shaped sealing material formed of a silicone resin, and particularly to a sheet-shaped sealing material and a layered sheet-shaped sealing material used for a solar cell panel.

Background Art

Conventionally, sealing materials composed of foamed bodies have been used in various fields such as solar cell-related fields and automobile-related fields. For example, in the solar cell-related fields, when the peripheral end portion of a solar cell panel is fixed to a support frame material, a sealing material is disposed between the peripheral end portion of the panel and the support frame material and prevents the entry of water and the like into the panel. As such a solar cell sealing material, conventionally, foamed bodies obtained by foaming rubbers such as EPDMs with foaming agents such as azodicarboxylic acid amide, acrylic foamed bodies, silicone foams, and the like have been used (for example, see Patent Literatures 1 to 4).

It is desired that sealing materials used for solar cells are those that exhibit high shock absorbency and sealing properties even if the thickness is small. In addition, since solar cells are installed and used outdoors for a long period, it is desired that the sealing materials are those that have high cold and heat resistance and moisture resistance so that performance is maintained even if temperature and humidity changes due to a difference in temperature between day and night or between the four seasons occur. Furthermore, in order to prevent early deterioration due to sunlight, high light resistance performance is also required of the sealing materials. However, the above foamed bodies and silicone foams cannot sufficiently satisfy the required performance.

In addition, in the automobile-related fields and the like, sealing materials composed of foamed bodies may be used as sealing materials as fillings in the gaps between parts. Such automobile sealing materials are particularly used for the waterproofing and dustproofing of power sources such as engines and their periphery, and lamps such as front and rear lamps. The sealing materials are affected by solar radiation or heat generation from engines, lamps and the like, and exposed to high temperature, and exposed to low temperature during parking and stopping for a long time in winter and the like, and sealing performance having heat resistance and cold resistance is required. In addition, for the sealing materials, low cost and small height difference are required in terms of design, and small thickness is also desired.

In addition, it is known that as a sealing material, for example, a closed cell sponge rubber obtained by crosslinking an uncrosslinked rubber in which previously thermally expanded microballoons are mixed in a rubber compound is used (see Patent Literature 5). Here, when the closed cell sponge rubber disclosed in Patent Literature 5 is used for an automobile sealing material, a fluororubber is used as the rubber compound, as shown in Example 4. However, when a fluororubber is used in a sealing material, the cold and heat resistance is good, but a problem is that when the thickness is decreased, it is difficult to keep high shock absorbency and sealing properties.

In addition, Patent Literature 6 discloses, as a heat-insulating sheet for electronic equipment, a silicone foam in which a hollow filler such as microballoons is blended. However, the expansion ratio and the like of a heat-insulating sheet differ greatly from those of a sealing material due to a difference in function, and usually, a heat-insulating sheet is not converted to a sealing material.

Citation List

Patent Literature

Patent Literature 1: Japanese Patent Laid-Open No. 2009-71233
Patent Literature 2: Japanese Patent Laid-Open No. 2012-1707
Patent Literature 3: Japanese Patent Laid-Open No. 2000-226909
Patent Literature 4: German Patent Application Publication No. 10 2009 011164
Patent Literature 5: Japanese Patent No. 3274071
Patent Literature 6: Japanese Patent No. 4114050

Summary of Invention

Technical Problem

The present invention has been made in view of the above problems, and it is an object of the present invention to provide a sheet-shaped sealing material and a layered sheet-shaped sealing material that have excellent shock absorbency, sealing properties, cold and heat resistance, and light resistance even if the thickness is decreased.

Solution to Problem

As a result of diligent study, the present inventors have found that by dispersing a plurality of particles each having a cavity portion therein in a silicone resin to make the cavity portions the cells of a foamed body, a sheet-shaped sealing material can have good shock absorbency, sealing properties, cold and heat resistance, and moisture resistance even if the thickness is small, and the sheet-shaped sealing material further has excellent light resistance and is useful for solar cell and sealing materials for vehicle and the like, thus completing the present invention below.
Specifically, the present invention provides the following (1) to (17).

(1) A sheet-shaped sealing material comprising: a silicone resin (A); and a plurality of particles (B) dispersed in the silicone resin (A) and each having a cavity portion therein.
(2) The sheet-shaped sealing material according to the above (1), having a thickness of 0.05 to 2.5 mm and an expansion ratio of 2 to 8 times.
(3) The sheet-shaped sealing material according to the above (1) or (2), wherein the plurality of particles (B) comprise expanded foamed particles and have an average particle diameter of 40 to 200 $\mu$m.
(4) The sheet-shaped sealing material according to any of the above (1) to (3), being a sealing material for solar cell panel.
(5) A layered sheet-shaped sealing material comprising: the sheet-shaped sealing material according to any of the above (1) to (4); and a resin film provided on one surface of the sheet-shaped sealing material.
(6) The layered sheet-shaped sealing material according to the above (5), wherein the sheet-shaped sealing material has a closed cell ratio of 70% or more, and a 20% compressive stress at 20°C of the sheet-shaped sealing material is 0.05 to 0.7 MPa.
(7) The layered sheet-shaped sealing material according to the above (5) or (6), wherein a moisture permeability of the resin film in a water vapor moisture permeability test prescribed in JIS Z 0208 is 30 g/m$^2$·day or less, and a thickness of the resin film is 0.01 to 0.25 mm.
(8) The layered sheet-shaped sealing material according to any of the above (5) to (7), wherein a breaking elongation of the resin film after a lapse of 1000 hours under UV exposure test conditions prescribed in UL746C is 70% or more.
(9) The layered sheet-shaped sealing material according to any of the above (5) to (8), wherein the resin film is an olefin-based resin film, a polyester-based resin film, or an ethylene-vinyl alcohol copolymer-based resin film.
(10) The layered sheet-shaped sealing material according to any of the above (5) to (9), wherein a tension at 5% extension of the sheet-shaped sealing material is 15 to 50% of a tension at 5% extension of the resin film.
(11) The layered sheet-shaped sealing material according to any of the above (5) to (10), being a sealing material for solar cell panel.
(12) A solar cell module comprising: a solar cell panel; a fixing member that fixes a peripheral end portion of the solar cell panel; and the sealing material for solar cell panel according to the above (4) or (11) that is disposed between the fixing member and the solar cell panel.
(13) The solar cell module according to the above (12), wherein the sealing material for solar cell panel comprises the layered sheet-shaped sealing material, and the sheet-shaped sealing material is disposed on a solar cell panel side in the layered sheet-shaped sealing material.
(14) A method for manufacturing a sheet-shaped sealing material, comprising: curing a sealing material composition comprising a curable silicone resin composition and a plurality of particles each having a cavity portion therein to obtain a sheet-shaped sealing material having cells formed by the cavity portions of the particles.
(15) The method for manufacturing a sheet-shaped sealing material according to the above (14), comprising: heating and foaming a plurality of particles having foamability to obtain a plurality of foamed particles each having a cavity portion therein; and mixing the foamed particles and the curable silicone resin composition to obtain the sealing material composition.
(16) The method for manufacturing a sheet-shaped sealing material according to the above (14) or (15), comprising steps of: mixing a part of a base resin of the curable silicone resin composition and a plurality of particles having foamability, and then heating and expanding the particles having foamability to form foamed particles each having a cavity portion therein to obtain a mixture comprising a plurality of the foamed particles and the part of the base resin of the curable silicone resin composition; blending at least a remainder of the base resin and a curing agent of the curable silicone resin composition into the mixture to obtain a sealing material composition; and heating and curing the sealing material composition formed into a sheet shape to obtain the sheet-shaped sealing material.

(17) A method for manufacturing a layered sheet-shaped sealing material, comprising: curing a sealing material composition that comprises a curable silicone resin composition and a plurality of particles each having a cavity portion therein and that is provided on a resin film to obtain a layered sheet-shaped sealing material having the resin film provided on one surface of a sheet-shaped sealing material having cells formed by the cavity portions of the particles.

Advantageous Effects of Invention

According to the present invention, it is possible to provide a sheet-shaped sealing material that has excellent shock absorbency, sealing properties, cold and heat resistance, moisture resistance, and light resistance even if the thickness is decreased.

Brief Description of Drawings

[Figure 1] Figure 1 is a schematic cross-sectional view showing one example of a layered sheet-shaped sealing material of the present invention.

[Figure 2] Figure 2 is a partial perspective view showing a solar cell module to which a sealing material for solar cell panel of the present invention is applied.

[Figure 3] Figure 3 is a partial cross-sectional view showing the solar cell module to which the sealing material for solar cell panel of the present invention is applied.

[Figure 4] Figure 4 is a perspective view showing an example in which a sheet-shaped sealing material of the present invention is applied to a sealing material for an engine cover.

[Figure 5] Figure 5 is a schematic cross-sectional view showing an example in which the sheet-shaped sealing material of the present invention is applied to a sealing material for an automobile lamp.

[Figure 6] Figure 6 is a schematic cross-sectional view showing an example in which the sheet-shaped sealing material of the present invention is applied to a sunroof of an automobile.

Description of Embodiments

The present invention will be described in more detail below with reference to embodiments.

[Sheet-shaped Sealing Material]

A sheet-shaped sealing material according to the present invention comprises a silicone resin (A) and a plurality of particles (B) dispersed in the silicone resin (A) and each having a cavity portion therein. In the present invention, by such a configuration, the sheet-shaped sealing material is formed of the silicone resin (A) having a plurality of cells therein, and it is possible to provide a sheet-shaped sealing material that has excellent shock absorbency, sealing properties, cold and heat resistance, light resistance, and moisture resistance while having small thickness.

In addition, the sheet-shaped sealing material according to the present invention is preferably a foamed body. The foamed body may be a cured product obtained by foaming a sealing material composition when curing it, but is preferably one obtained by curing a sealing material composition comprising foamed particles that have been foamed, as described later. Thus, the thickness of the sheet-shaped sealing material is easily made to be decreased with various performance of the sheet-shaped sealing material maintained well.

In addition, the sheet-shaped sealing material according to the present invention is different from those referred to as a "caulking" and a "sealant." The sealant and the like exhibit sealing performance by adhesion performance without providing a gap in a void portion. In other words, the sealant cannot exhibit surface adhesiveness and cannot exhibit sealing performance in a state in which a curing reaction and a crosslinking reaction are completed. Typical examples of the sealant include silicone sealants such as SH780 manufactured by Dow Corning Toray Co., Ltd.

On the other hand, in the sheet-shaped sealing material according to the present invention, a curing reaction and a crosslinking reaction are already completed, and the sheet-shaped sealing material does not exhibit surface adhesiveness but can exhibit sealing performance.

[Silicone Resin (A)]

The silicone resin (A) according to the present invention is obtained by curing a curable silicone resin composition, and is preferably a two-part liquid and addition-reaction type silicone resin. Such a curable silicone resin composition comprises, for example, (A1) an organopolysiloxane having at least two alkenyl groups in one molecule, (A2) an organohydrogenpolysiloxane having at least two hydrogen atoms that are bonded to silicon atom in one molecule, and (A3) a platinum-based catalyst.

The silicone resin (A) is different from a polyether having a silyl group at a terminal referred to as a "modified silicone." Typical examples of the modified silicone include "MS Polymer" manufactured by KANEKA CORPORATION.

The organopolysiloxane that is the (A1) component constitutes a base resin for the silicone resin and has at least two alkenyl groups that are bonded to silicon atom. As the alkenyl group, a vinyl group, an allyl group, and the like are illustrated. In addition, examples of the organic groups bonded to the silicon atoms other than the alkenyl groups include alkyl groups having 1 to 3 carbon atoms illustrated by a methyl group, an ethyl group, and a propyl group; aryl groups illustrated by a phenyl group and a tolyl group; and substituted alkyl groups illustrated by a 3,3,3-trifluoropropyl group and a 3-chloropropyl group. The molecular structure of the (A1) component may be either linear or branched.

The molecular weight of the (A1) component is not particularly limited, but the viscosity at 23°C is preferably 0.1 Pa·s or more, more preferably 0.3 to 15 Pa·s, and further preferably 0.5 to 10 Pa·s. In the present invention, two or more of the above organopolysiloxanes may be used in combination.

The organohydrogenpolysiloxane that is the (A2) component constitutes a curing agent, and the silicon atom-bonded hydrogen atoms of the (A2) component undergo an addition reaction with the silicon atom-bonded alkenyl groups of the organopolysiloxane in the (A1) component in the presence of the platinum-based catalyst that is the (A3) component, to crosslink and cure the curable silicone resin composition. The (A2) component needs to have at least two hydrogen atoms that are bonded to silicon atom in one molecule. In the (A2) component, examples of the organic groups bonded to the silicon atoms include alkyl groups having 1 to 3 carbon atoms illustrated by a methyl group, an ethyl group, and a propyl group; aryl groups illustrated by a phenyl group and a tolyl group; and halogen atom-substituted alkyl groups illustrated by a 3,3,3-trifluoropropyl group and a 3-chloropropyl group. The molecular structure of the (A2) component may be any of linear, branched, cyclic, and network-like structures.

The molecular weight of the (A2) component is not particularly limited, but the viscosity at 23°C is preferably 0.005 to 8 Pa·s, and more preferably 0.01 to 4 Pa·s.

The amount of the (A2) component added is determined such that the molar ratio of the hydrogen atoms bonded to silicon atom in this component to the alkenyl groups bonded to silicon atom in the (A1) component is (0.5:1) to (20:1), and the molar ratio is preferably in the range of (1:1) to (3:1). When this molar ratio is 0.5 or more, the curability is relatively good, and when this molar ratio is 20 or less, the hardness of the sheet-shaped sealing material is of suitable magnitude.

The platinum-based catalyst that is the (A3) component is used for curing the curable silicone resin composition. As the platinum-based catalyst, platinum fine powders, platinum black, chloroplatinic acid, platinum tetrachloride, olefin complexes of chloroplatinic acid, alcohol solutions of chloroplatinic acid, complex compounds of chloroplatinic acid and alkenylsiloxanes, rhodium compounds, palladium compounds, and the like are illustrated. In addition, in order to increase the pot life of the curable silicone resin composition, thermoplastic resin particles containing these platinum-based catalysts may be used.

The amount of this platinum-based catalyst added is usually 0.1 to 500 parts by weight, and preferably in the range of 1 to 50 parts by weight, as a platinum-based metal, based on 1,000,000 parts by weight of the (A1) component. By setting the amount of the platinum-based catalyst added to 0.1 parts by weight or more, the addition reaction can proceed suitably. By setting the amount of the platinum-based catalyst added to 500 parts by weight or less, the present invention can be carried out economically. The platinum-based catalyst that is the (A3) component is usually previously added to either a base resin or a curing agent in a two-part curable type.

Examples of commercial products of the curable silicone resin composition include the two-component heat-curable liquid silicone rubber "TSE3032" manufactured by Momentive Performance Materials Japan LLC.

[Particles]

The average particle diameter of the particles (B) differs greatly depending on the thickness of the sheet-shaped sealing material to be made, and is preferably 10 μm or more, more preferably 20 μm or more, and further preferably 40 μm or more, and is preferably 300 μm or less, more preferably 200 μm or less, and further preferably 150 μm or less. By setting the average particle diameter to 300 μm or less, closed cells are formed by the particles (B) and the sheet-shaped sealing material can function as a sealing material even if the sheet-shaped sealing material is extremely thin. In addition, by setting the average particle diameter to 10 μm or more, the shock resistance and the sealing properties can be made good.

The plurality of particles (B) are dispersed in the silicone resin (A) and each have a cavity portion therein. The particle diameters of the plurality of particles (B) may show a single distribution but may show different distributions. For example, the particle diameters of the plurality of particles (B) preferably show three types of particle diameter distributions because a larger number of the particles (B) can be contained compared with the particles (B) having a single particle diameter distribution.

"Showing different distributions" means that two or more peaks are present when the particle diameters of, for example, 100 particles (B) are measured by a method described later and a particle distribution graph is prepared. "Showing a single distribution" and "showing three types of particle diameter distributions" mean that one peak is present and three peaks are present, respectively.

Examples of the shape of the particles (B) include a spherical shape, a plate shape, a needle shape, and an irregular shape. From the viewpoint of still further increasing the filling properties and dispersibility of the particles (B), the particles (B) are preferably spherical. The aspect ratio of the spherical particles is 5 or less, preferably 2 or less, and more preferably 1.2 or less.

The average particle diameter herein is the average value of measured values when the sizes of the primary particles of 100 particles in an observed field of view are measured using a scanning electron microscope, an optical microscope, or the like. When the above particles are spherical, the average particle diameter means the average value of the diameters of the particles. When the above particles are nonspherical, the average particle diameter means the average value of the major axes of the particles. In addition, the aspect ratio is represented by the ratio of the major axis to the minor axis (the average value of the major axes/the average value of the minor axes).

The particles (B) are the so-called hollow particles each having an outer shell in which a cavity portion is present. In the present invention, by forming cells by the hollow particles, the sheet-shaped sealing material can be made thinner while the compressive stress and the like of the sheet-shaped sealing material are made good. The particles (B) each preferably have one cavity portion therein. The particles (B) are preferably organic particles, that is, the material of the outer shells of the particles (B) is preferably an organic compound.

The void ratio of the particles (B) is preferably 50% or more, more preferably 80% or more, and further preferably 90% or more, and is preferably 98% or less, more preferably 97% or less, and further preferably 96% or less. When the above void ratio is 50% or more, the shock absorption resistance, sealing properties, and flexibility of the sealing material increase. When the above void ratio is set to 80% or more or 90% or more, the shock absorption resistance, sealing properties, and flexibility of the sealing material increase still further. When the above void ratio is 98% or less, the strength of the particles (B) increases, and the outer shells do not crack easily. When the above void ratio is set to 97% or less or 96% or less, the strength increases still further.

The void ratio herein means a volume ratio that represents the volume of the void portions in the total volume of the above particles (B) by percentage (%). Specifically, for example, 100 particles are arbitrarily extracted from a photograph taken by a microscope, and the major and minor axes of the particle outer diameters, and the major and minor axes of the particle void portions are measured. Then, the void ratio of each particle is calculated by the following formula, and the average value of the void ratios of the 100 particles is taken as the void ratio of the particles (B).

Void ratio (% by volume) = ((Void portion major axis + Void portion minor axis)/(Major axis of the outer diameter + Minor axis of the outer diameter))$^3$ x 100

The particles (B) are preferably foamed particles expanded so as to form cavity portions therein. By the use of the foamed particles, the shock resistance performance and flexibility of the sheet-shaped sealing material increase still further, and the thickness of the sheet-shaped sealing material can be decreased.

The above foamed particles are preferably foamed particles obtained by expanding particles having thermal foamability, more preferably foamed particles obtained by thermally expanding thermally-expandable microcapsules. In the thermally-expandable microcapsules, a volatile substance such as a low boiling point solvent is contained in an outer shell resin. By heating, the outer shell resin softens, and the contained volatile substance volatilizes or expands, and therefore, the outer shells expand due to the pressure, and the particle diameters increase to form foamed particles. The temperature at which the thermally-expandable microcapsules are expanded is not particularly limited but is preferably greater than expansion start temperature and less than maximum expansion temperature described later.

The outer shells of the thermally-expandable microcapsules are preferably formed of a thermoplastic resin. For the thermoplastic resin, one or more selected from vinyl polymers of ethylene, styrene, vinyl acetate, vinyl chloride, vinylidene chloride, acrylonitrile, butadiene, chloroprene, and the like and copolymers thereof; polyamides such as nylon 6 and nylon 66; and polyesters such as polyethylene terephthalate can be used. Copolymers of acrylonitrile are preferred in that the contained volatile substance does not easily pass through them. As the volatile substance contained in the thermally-expandable microcapsules, one or more low boiling point liquids selected from hydrocarbons having 3 to 7 carbon atoms such as propane, propylene, butene, normal butane, isobutane, isopentane, neopentane, normal pentane, hexane, and heptane; petroleum ether; halides of methane such as methyl chloride and methylene chloride; chlorofluorocarbons such as $CCl_3F$ and $CCl_2F_2$; tetraalkylsilanes such as tetramethylsilane and trimethylethylsilane; and the like are used.

Preferred examples of the thermally-expandable microcapsules include microcapsules comprising a copolymer of acrylonitrile and vinylidene chloride as an outer shell resin and containing a hydrocarbon having 3 to 7 carbon atoms such as isobutene therein.

The thermally-expandable microcapsules before foaming have an average particle diameter of preferably 1 μm or more, more preferably 4 μm or more, and preferably less than 50 μm, more preferably less than 40 μm. By setting the average particle diameter to the above lower limit value or more, the aggregation of the particles is not easily caused, and the thermally-expandable microcapsules are easily uniformly dispersed in the resin. In addition, by setting the average particle diameter to the upper limit value or less, a decrease in the number of cells in the thickness direction and an increase in the size of the cells are prevented when a foamed body is formed, and quality such as mechanical properties can be stabilized.

In addition, the thermally-expandable microcapsules preferably expand so that the average particle diameter preferably increases 2 times or more and 10 times or less, to form the above foamed particles. In addition, the expansion start temperature of the thermally-expandable microcapsules is preferably 95 to 150°C, and further preferably 105 to 140°C. In addition, the maximum expansion temperature is preferably 120 to 200°C, and further preferably 135 to 180°C.

Examples of commercial products of the thermally-expandable microcapsules include "EXPANCEL" manufactured by Japan Fillite Co., Ltd., "ADVANCELL" manufactured by SEKISUI CHEMICAL CO., LTD., "Matsumoto Microsphere" manufactured by Matsumoto Yushi-Seiyaku Co., Ltd., and "Microsphere" manufactured by KUREHA CORPORATION.

The sheet-shaped sealing material in the present invention may further contain particles (C) dispersed in the silicone resin (A) and each having no cavity portion therein, in addition to the particles (B). The particles (C) may be any of inorganic particles, organic particles, and organic-inorganic composite particles.

Examples of the particles (C) include inorganic particles formed of one or more inorganic compounds selected from alumina, synthetic magnesite, silica, boron nitride, aluminum nitride, silicon nitride, silicon carbide, zinc oxide, magnesium oxide, talc, mica, and hydrotalcite. Both inorganic particles and organic particles may be used.

In the present invention, preferably 0.1% by weight or more, more preferably 1% by weight or more, and preferably 30% by weight or less, more preferably 10% by weight or less, of foamed particles (unexpanded) for forming the particles (B) are blended in 100% by weight of a sealing material composition for forming the sheet-shaped sealing material.

When the content of the particles (B) and the curable silicone resin composition is set to the above lower limit or more and the above upper limit or less, the sealing properties and shock absorbency of the sheet-shaped sealing material and the strength of the sheet increase with a good balance.

[Other Components]

The sealing material composition for forming the sheet-shaped sealing material may further comprise various additives such as a coupling agent, a dispersing agent, an antioxidant, an antifoaming agent, a coloring agent, a modifying agent, a viscosity-adjusting agent, a light-diffusing agent, a curing inhibitor, and a flame retardant, as required. Examples of the above coloring agent include pigments. Examples of the above viscosity-adjusting agent include silicone oils.

<Thickness>

The sheet-shaped sealing material has a thickness of preferably 0.05 mm or more and preferably 2.5 m or less. In the present invention, by setting the thickness to 0.05 mm or more, high shock absorption performance and sealing properties can be ensured, and by setting the thickness to 2.5 m or less, the thinning of a solar cell panel described later, the size reduction and weight reduction of various vehicle parts of internal combustion engines, internal combustion engine peripherals, or the like, and the like are possible, and the cost effectiveness is good. In addition, when the sheet-shaped sealing material is used as a sealing material for solar cell panel, it is prevented from being thick more than necessary with respect to the designed gap between a solar cell panel and a support frame material, and it is easy to insert a solar cell module to which the sealing material is attached into a support frame material. From these viewpoints, the thickness is more preferably 0.1 mm or more, and particularly preferably 0.5 mm or more. In addition, the thickness is more preferably 2 mm or less, and particularly preferably 1 mm or less.

<Expansion Ratio>

In the present invention, the expansion ratio of the sheet-shaped sealing material is preferably 2 times or more, more preferably 2.5 times or more, and is preferably 8 times or less, more preferably 7 times or less. When the expansion ratio is the above lower limit value or more, the shock absorbency, sealing properties, and flexibility can be high, and, for example, compression is easy even in a portion where the sheet-shaped sealing material is overlapped. In addition, when the expansion ratio is the above upper limit value or less, the strength of the sheet-shaped sealing material increases, and the shock resistance and the like can be increased.

<Closed Cell Ratio and Compressive Stress>

The sheet-shaped sealing material of the present invention preferably has a closed cell ratio of 70% or more and a 20% compressive stress at 20°C of 0.05 to 0.7 MPa. In the sheet-shaped sealing material, by setting the closed cell ratio and the compressive stress in certain ranges in this manner, the sealing properties and compressive properties are good and sufficient waterproofness and dustproofness and shock resistance performance can be ensured even when a resin film is provided thereon as described later.

More specifically, when the closed cell ratio is 70% or more, moisture does not easily enter the cells in the sheet-shaped sealing material, and high sealing properties are easily ensured. In addition, when the closed cell ratio is 70% or more, the air in the cells does not leak easily to the outside, and the range of the compressive stress is easily set in the above range. From these viewpoints, the closed cell ratio is preferably 80% or more, more preferably 90% or more, and further preferably 95% or more.

In the sheet-shaped sealing material of the present invention, the cavity portions of the particles (B) usually form closed cells, and the closed cell ratio increases easily.

In the sheet-shaped sealing material, when the 20% compressive stress at 20°C is 0.05 MPa or more, in a case where the sheet-shaped sealing material is used in a solar cell panel, the entry of moisture into the panel can be prevented even if the solar cell panel is exposed to wind and rain and is cleaned by a cleaning machine. In addition, the strength of the sheet-shaped sealing material can also be made good.

In addition, in the sheet-shaped sealing material, when the 20% compressive stress at 20°C is 0.7 MPa or less, the flexibility is good, sufficient shock absorbency is obtained, and a solar cell panel and so on are prevented from being damaged by shock. Furthermore, the resistance in inserting a solar cell panel to which the sheet-shaped sealing material or a layered sheet-shaped sealing material described later is attached into a support frame material decreases, and the workability is good. In addition, when the compressive stress is in the above range, sufficient watertightness can be obtained even if no pressure-sensitive adhesive is used in order to increase the close-contact property between a solar cell panel and a support frame body. Therefore, a decrease in workability due to the tackiness of a pressure-sensitive adhesive is prevented.

The compressive stress of a silicone resin foamed body (A) according to an embodiment of the present invention is obtained based on JIS K 6767.

The closed cell ratio is measured, for example, by the following procedure.

A test piece having a planar square shape having a side of 5 cm is cut from the sheet-shaped sealing material. The thickness of the test piece is measured, and the apparent volume of the test piece $V_1$ is calculated, and the weight of the test piece $W_1$ is measured. Next, the apparent volume of the cells $V_2$ is calculated based on the following formula. The density of the resin constituting the test piece is taken as p $g/cm^3$.

$$\text{Apparent volume of the cells } V_2 = V_1 - W_1/\rho$$

Next, the test piece is sunk in distilled water at 23°C at a depth of 100 mm from the water surface, and a pressure of 15 kPa is applied to the test piece over 3 minutes. The pressure is released in the water, and then, the test piece is taken out of the water, moisture attached to the surface of the test piece is removed, the weight of the test piece $W_2$ is measured, and an open cell ratio $F_1$ and a closed cell ratio $F_2$ are calculated based on the following formulas.

$$\text{Open cell ratio } F_1 \text{ (\%) } = 100 \times (W_2 - W_1)/V_2$$

$$\text{Closed cell ratio } F_2 \text{ (\%) } = 100 - F_1$$

The sheet-shaped sealing material of the present invention may be used alone as a sealing material, but may be used with another layer provided on one surface or both surfaces of the sheet-shaped sealing material. For example, the sheet-shaped sealing material is preferably used in a layered sheet-shaped sealing material comprising the sheet-shaped sealing material and a resin film provided on one surface of the sheet-shaped sealing material.

Furthermore, the sheet-shaped sealing material may be one having a pressure-sensitive adhesive layer that is provided on one surface thereof. In this case, the pressure-sensitive adhesive layer may be provided directly on the sheet-shaped sealing material but may be provided via another layer such as a primer.

The pressure-sensitive adhesive layer is formed, for example, by coating one surface of the sheet-shaped sealing material with a pressure-sensitive adhesive. As the pressure-sensitive adhesive, acrylic pressure-sensitive adhesive, urethane-based pressure-sensitive adhesive, rubber-based pressure-sensitive adhesive, silicone pressure-sensitive adhesive, and the like can be used, and acrylic pressure-sensitive adhesive are preferred. The pressure-sensitive adhesive layer is repeelable, and can be peeled, for example, from an adherend or the like even after being once adhered to the adherend.

As the primer constituting the primer layer, adhesion promoters for increasing the adhesiveness between the pressure-sensitive adhesive layer or the resin film and the sheet-shaped sealing material, and the like can be used. Specific examples of commercial products of the adhesion promoters include P5200 from Dow Corning and XP80-A5363 from Momentive.

[Layered Sheet-shaped Sealing Material]

The configuration of the layered sheet-shaped sealing material of the present invention will be described in more detail below.

The layered sheet-shaped sealing material comprises the above sheet-shaped sealing material and a resin film provided on one surface of the sheet-shaped sealing material. Such a layered sheet-shaped sealing material is particularly preferably used as a sealing material for solar cell panel.

Here, in the layered sheet-shaped sealing material, the resin film is integrated with the sheet-shaped sealing material. The resin film and the sheet-shaped sealing material may be adhered and fused each other, but need not necessarily be adhered or fused and may be layered such that the resin film is easily peeled from the sheet-shaped sealing material. However, it is preferred that the silicone resin composition before curing be spread on the resin film, and then thermally cured because it is virtually difficult to integrate the sheet-shaped sealing material after curing with the resin film without pretreatment with a primer or the like. The resin film and the sheet-shaped sealing material that are integrated are used as the sealing material. The layered sheet-shaped sealing material can have increased weather resistance, insulating properties, and moisture permeation resistance performance by comprising the resin film.

The resin film may be provided directly on the sheet-shaped sealing material but may be adhered, fused, and the like to the sheet-shaped sealing material via a primer layer or a pressure-sensitive adhesive layer. Examples of the primer layer include those described above.

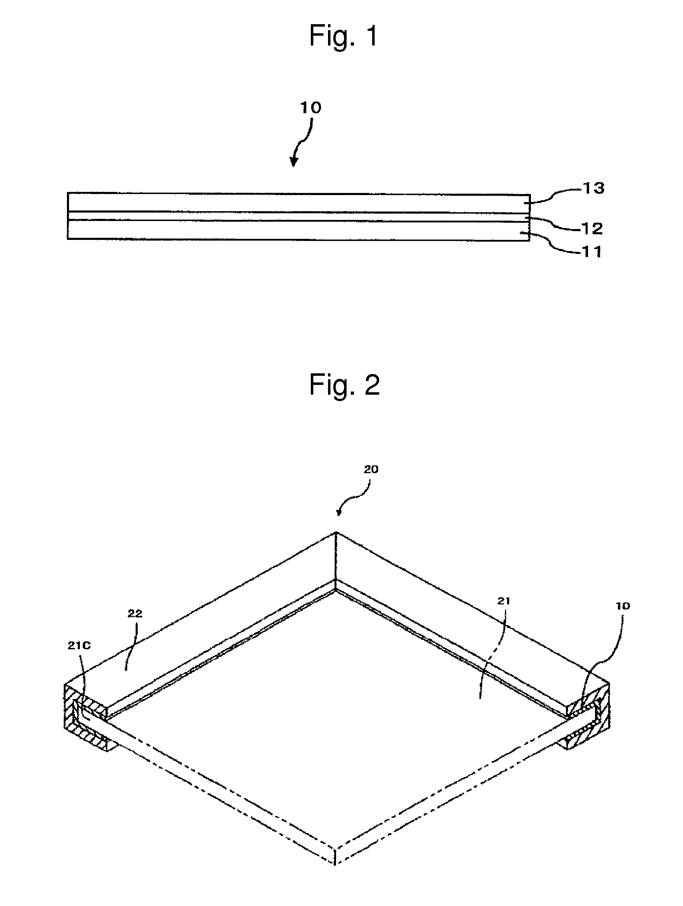

Figure 1 shows one example of a layered sheet-shaped sealing material 10 and shows the layered sheet-shaped sealing material 10 in which a resin film 13 is provided on one surface of a sheet-shaped sealing material 11 via a primer layer 12.

In such a layered sheet-shaped sealing material 10, the sheet-shaped sealing material 11 has the above-described compressive stress and has excellent compressive properties, and therefore, high sealing properties and shock absorption performance can be ensured even if a resin film having poor compressive properties is provided thereon. In addition, in the layered sheet-shaped sealing material of the present invention, by providing the resin film, the entry of moisture can be more suitably prevented, combined with cells being formed by the particles (B) and the closed cell ratio being in the above range.

In the layered sheet-shaped sealing material 10, a pressure-sensitive adhesive layer may be provided on the surface of the sheet-shaped sealing material 11 opposite to the surface on which the resin film 13 is provided.

In this case, the pressure-sensitive adhesive layer is the same as the above one and, for example, may be provided on the sheet-shaped sealing material via a primer layer. However, the layered sheet-shaped sealing material of the present invention can exhibit high sealing properties even if the pressure-sensitive adhesive layer is not provided on the sheet-shaped sealing material.

<Resin Film>

As the above resin film, resins having excellent breaking strength and dielectric breakdown voltage are preferably used. Specific examples of resins that can be used for the resin film include ethylene-vinyl alcohol copolymer (EVOH)-based resins, olefin-based resins such as polyethylene (PE)-based resins and polypropylene (PP)-based resins, polyester-based resins such as polyethylene terephthalate (PET) and polybutylene terephthalate (PBT), polystyrene (PS)-based resins, polycarbonate (PC)-based resins, polyacetal (POM)-based resins, polyurethane (PU)-based resins, polyethersulfone (PES)-based resins, polytetrafluoroethylene (PTFE)-based resins, polyimide-based resins, silicone-based resins, phenolic resins, epoxy-based resins, ABS-based resins, polyphenylene sulfide (PPS)-based resins, and liquid crystal polymer (LCP)-based resins. In addition, a plurality of the above resins may be layered (coextruded or laminated).

Resin films using olefin-based resins, EVOH-based resins, or silicone-based resins among the above resins can be adhered to and integrated with the sheet-shaped sealing material even without the primer layer or the pressure-sensitive adhesive layer as described above. On the other hand, resin films using polyester-based resins such as polyethylene terephthalate, PC-based resins, PTFE-based resins, PS-based resins, POM-based resins, PU-based resins, PPS-based resins, LCP-based resins, PES-based resins, PTFE-based resins, ABS-based resins, phenolic resins, polyimide-based resins, and epoxy-based resins have low adhesiveness to the sheet-shaped sealing material and peel easily, and therefore, it is preferred that the resin films be adhered and integrated via a primer layer or a pressure-sensitive adhesive layer, or a coupling agent be blended into or applied to the sealing material composition and/or the resin films as described later.

In the present invention, by using the above resins, the sheet-shaped sealing material can be reinforced.

In addition, in the present invention, the sheet-shaped sealing material is a foamed body having cells, and therefore may have poor dielectric breakdown strength and moisture permeability, but in the layered sheet-shaped sealing material, the dielectric breakdown strength and moisture permeability can be made good by providing these resin films.

In addition, from the viewpoint of making dielectric breakdown strength particularly good, the thickness and expansion ratio of the sheet-shaped sealing material and the thickness of the resin film are important factors. From this viewpoint, it is preferred that the sheet-shaped sealing material and the expansion ratio be set in the above-described ranges, and on the other hand, the thickness of the resin film be set to 0.01 to 0.25 mm. The thickness of the resin film is more preferably 0.02 to 0.15 mm.

The layered sheet-shaped sealing material of the present invention is preferred as a sealing material for solar cell panel because, for example, by setting the thickness of the resin film to 0.01 mm or more while setting the thickness of the sheet-shaped sealing material to 0.1 mm or more and setting its expansion ratio to 8 times or less, the dielectric breakdown voltage can be set to a suitable magnitude, and the moisture permeability can also be decreased. In addition, by setting the thickness of the resin film to 0.25 mm or less, the desired performance can be obtained while an increase in material cost is prevented. In addition, by setting the thickness of the resin film to 0.25 mm or less, too high rigidity of the layered sheet-shaped sealing material is prevented, and problems, for example, curl occurring when the layered sheet-shaped sealing material being in the form of being wound in a roll shape, do not occur easily. Furthermore, by setting the thickness of the resin film to 0.15 mm or less, conformability to an uneven surface is good, and performance as the sealing material can be further increased.

In addition, an ultraviolet deterioration inhibitor such as an ultraviolet absorbent may be blended into the resin film from the viewpoint of light resistance.

Among the above-described resins, EVOH-based resin films and polyester-based resin films such as PET and PBT are preferred in terms of excellent water vapor barrier properties. In addition, in terms of excellent water vapor barrier properties, weather resistance, and light resistance, olefin-based resin films such as polyethylene-based films are preferred, and polyethylene-based resin films in which an ultraviolet deterioration inhibitor such as an ultraviolet absorbent is blended are also preferably used.

In addition, from the viewpoint of the extensibility of the resin film, olefin-based, particularly polyethylene- and polypropylene- based, resin films are desired. With using the resin film having extensibility, when the sheet-shaped sealing material is provided on a periphery of a solar cell or the like, the sheet-shaped sealing material can be closely contacted therewith with applying tension thereto, and therefore, the close-contact property with the solar cell panel or the like is increased, and as a result, watertightness can be improved.

From these viewpoints, when the layered sheet-shaped sealing material is used in solar cell panel applications, EVOH-based resin films and olefin-based resin films are preferred for the resin film.

It is desired that the water vapor moisture permeability of the resin film in the water vapor moisture permeability test prescribed in JIS Z 0208 is 30 g/m$^2\cdot$day or less.

When the moisture permeability is 30 g/m$^2\cdot$day or less, combined with the thickness of the resin film being in the above range, a decrease in the performance of a solar cell panel due to the entry of moisture can be prevented when the layered sheet-shaped sealing material is used as a sealing material for solar cell panel. From the above viewpoint, a preferred range of the moisture permeability is 10 g/m$^2\cdot$day or less, and more preferably 5 g/m$^2\cdot$day or less.

As the resin film having low moisture permeability in this manner, EVOH-based resin films, olefin-based resin films such as polyethylene-based films and polypropylene-based films, polyester-based resin films such as PET and PBT, and the like among those described above can be used.

Examples of the ethylene-vinyl alcohol copolymers constituting the EVOH-based resin films having low moisture permeability include copolymers of ethylene and vinyl alcohol in which the ethylene is 24 to 48 mole %, preferably 38 to 44 mole %; namely the ethylene content is relatively high.

As such ethylene-vinyl alcohol copolymers, for example, "EVAL" manufactured by KURARAY CO., LTD. and "Soarnol" manufactured by The Nippon Synthetic Chemical Industry Co., Ltd. can be used.

In addition, in the case of films obtained by biaxially stretching ethylene-vinyl alcohol copolymers, the moisture permeability can be decreased even if the ethylene is 24 to 32 mole %. As such EVOH-based resin films, for example, "EVAL EF-XL" manufactured by KURARAY CO., LTD. can be used.

In addition, examples of the polyethylene constituting the polyethylene-based films include low density polyethylene, linear low density polyethylene, high density polyethylene, and mixtures thereof. Furthermore, ethylene-vinyl acetate copolymer (EVA) may be mixed into these.

Furthermore, examples of the polypropylene constituting the polypropylene-based films include a homopolymer type, a copolymer type, a block polymer type, and ethylene-propylene ternary copolymers. Furthermore, the above polyethylene and EVA may be mixed.

Examples of the films of polyester-based resins such as PET and PBT include "MAXBARRIER #12" manufactured by Mitsui Chemicals Tohcello, Inc. and "OT film" manufactured by SEKISUI CHEMICAL CO., LTD.

It is desired that the longitudinal (MD direction) breaking elongation of the resin film in a tensile test at 20°C is 70% or more. When this value is 70% or more, there is no decrease in handling properties during manufacture due to the above-described curl, and the layered sheet-shaped sealing material is conformed to a solar cell module surface to increase close-contact property.

Examples of the resin film in which the above breaking elongation is 70% or more include EVOH-based resin films, olefin-based resin films, polyester-based resin films, PU-based resins, PTFE-based resins, and polyimide-based resins among the above resin films.

Furthermore, from the viewpoint of the light resistance of the layered sheet-shaped sealing material, it is preferred that the above breaking elongation of the resin films be maintained even after a lapse of 1000 hours under the UV exposure test conditions prescribed in UL746C. In other words, it is preferred that the longitudinal breaking elongation be 70% or more even after the above test.

As the resin having high breaking elongation even after UV exposure in this manner, resins in which an ultraviolet deterioration inhibitor is blended are used. As the ultraviolet deterioration inhibitor, hindered amine-based light stabilizers, benzotriazole-based ultraviolet absorbents, hindered phenolic antioxidants, light-blocking pigments based on titanium oxide and/or carbon black, mixtures thereof, and the like can be used.

In addition, in the present invention, when the layered sheet-shaped sealing material is used as a solar cell panel sealing material, those in which the moisture permeability is 30 g/m$^2$·day or less, and the above breaking elongation after a lapse of 1000 hours under the UV exposure test conditions is 70% or more are preferred. As such resin films, the above-described EVOH-based resin films and polyolefin-based resin films in which an ultraviolet deterioration inhibitor is blended are preferred. Specific examples of the resin films include Bejitaron Super Kirinashi (product name, manufactured by SEKISUI FILM CO., LTD.) and HANAYAKA Kyojin UV Long (product name, manufactured by SEKISUI FILM CO., LTD.).

The sheet-shaped sealing material of the present invention is made of a foamed silicone and has weak tear strength, and therefore, the balance with the extension strength of the resin film is important. For example, the tension at 5% extension of the sheet-shaped sealing material is preferably set to 15 to 50% of the tension at 5% extension of the resin film. By setting the tension at 5% extension of the sheet-shaped sealing material to 15% or more of the tension at 5% extension of the resin film, the tension increases, and the close-contact property with the sheet-shaped sealing material is satisfactory. In addition, by setting the tension at 5% extension of the sheet-shaped sealing material to 50% or less of the tension at 5% extension of the resin film, the sheet-shaped sealing material can be prevented from tearing when it is unwound from a wound body and is brought in close contact with an object to be attached, or the like. In other words, by setting the tension at 5% extension in the above range, the sheet-shaped sealing material can be closely contacted with an object to be attached (for example, a solar cell panel) or the like with appropriate tension, and the above range is effective particularly when the sheet-shaped sealing material is brought in close contact therewith using automated equipment.

The tension at 5% extension herein refers to tension when a sample of width 25 mm x measured length 100 mm is extended by 5% in the length direction by a tensile tester, and the direction parallel to the MD direction of the resin film in the sealing material for solar cell panel is taken as the extension direction.

The layered sheet-shaped sealing material of the present invention preferably has the following compression set, dielectric breakdown voltage, and moisture permeability.

<Compression Set>

High compression set means that the resilience (compressive stress) in a long-term compressed state decreases. Namely, in the sealing material, the shock performance and the gap conformability decrease, that is, a gap occurs and water (including water vapor) enters, and therefore, low compression set is an important factor.

The layered sheet-shaped sealing material of the present invention desirably has a compression set of 15% or less, and further desirably 10% or less.

By setting the compression set to 15% or less, the sealing properties are good, and it is not necessary to make the layered sheet-shaped sealing material, for example, a so-called double-sided tape in which a pressure-sensitive adhesive layer is provided on both surfaces, in order not to cause a gap. By providing no pressure-sensitive adhesive layer on one surface (preferably either surface), it is not necessary to decrease shock performance in order to exhibit the tackiness effect of a pressure-sensitive adhesive, and a sealing material having higher shock resistance performance can be provided. In addition, by omitting a pressure-sensitive adhesive layer disposed outside, when the layered sheet-shaped sealing material is used as a sealing material for solar cell panel and inserted into a frame, extra frictional resistance due to a pressure-sensitive adhesive is eliminated, and the sheet-shaped sealing material corresponding to a core material is not deformed.

<Dielectric Breakdown Voltage>

The layered sheet-shaped sealing material of the present invention desirably has a dielectric breakdown voltage of 4 kV or more, and further desirably 5 kV or more, when used as a sealing material for solar cell panel.

The layered sheet-shaped sealing material needs to be insulated from a frame made of a metal (made of aluminum as a typical example) when used as a sealing material for solar cell panel because if electricity charged in the frame made of a metal flows into the solar cell panel through the sealing material for solar cell panel, the power generation capacity of the cells is decreased (deteriorated). When the dielectric breakdown voltage is set to 4 kV or more, the sheet-shaped sealing material or the layered sheet-shaped sealing material can be substantially insulated from the frame made of a metal.

<Moisture Permeability>

The layered sheet-shaped sealing material of the present invention desirably has a moisture permeability of 30 g/m$^2$·day or less, and further desirably 10 g/m$^2$·day or less, when used as a sealing material for solar cell panel described later. By setting the moisture permeability to the above upper limit value or less, it is possible to prevent the entry of water (including water vapor) into a solar cell panel and prevent a decrease in the power generation capacity of the cells.

[Methods for Manufacturing Sheet-shaped Sealing Material and Layered Sheet-shaped Sealing Material]

The sheet-shaped sealing material of the present invention is preferably obtained by curing a sealing material composition comprising a curable silicone resin composition as the main component and a plurality of particles each having a cavity portion therein. At this time, the sealing material composition is preferably obtained by previously heating and expanding a plurality of unfoamed particles having foamability such as expandable microcapsules to form a plurality of foamed particles, and mixing the foamed particles into a curable silicone resin composition. Here, the particles having foamability such as expandable microcapsules may be previously heated and expanded alone without being mixed with other components. Furthermore, the sealing material composition may be obtained by mixing a plurality of unfoamed particles having foamability into a part of a curable silicone resin composition, for example, a part of the base resin, previously heating the mixture to expand the particles having foamability to form foamed particles, and then further blending the remainder of the base resin, the curing agent, and so on constituting the curable silicone resin composition, into the mixture. When the particles having foamability are previously expanded before molding and curing in this manner, the control of the diameters of the cells is easy, and the sealing properties are easily increased.

However, in the present invention, a sealing material composition comprising a curable silicone resin composition, and particles having foamability before foaming may be cured. In this case, the particles having foamability are blended into the sealing material composition in an unexpanded state, and when the sealing material composition is heated and cured, the particles having foamability are thermally expanded simultaneously with the heating, and cavity portions are formed therein to form foamed particles.

In addition, the sealing material composition may comprise both previously heated and expanded foamed particles, and unfoamed (unexpanded) particles having foamability. The unfoamed particles having foamability may or may not be expanded during curing.

In the present invention, it is preferred that the sealing material composition be formed into a sheet shape by a pressing method, a roll transfer method, a roll casting method, a die casting method, a die extrusion method, or the like with the thickness controlled to the thickness of a sheet-shaped sealing material (for example, a thickness of 0.05 mm or more and 2.5 mm or less), and cured in this state to form a sheet-shaped sealing material.

In this manner, in the manufacturing method of the present invention, the steps of molding a sealing material composition into a sheet shape and curing the sheet is collectively performed. The product obtained by the curing is the above sheet-shaped sealing material having small thickness (for example, a thickness of 0.05 mm or more and 2.5 mm or less). The sheet-shaped sealing material obtained by this manufacturing method is not one obtained, for example, by slicing a thick sealing material parallel to the main plane. Therefore, a sheet-shaped sealing material having high sealing properties can be stably manufactured in the present invention.

In addition, in the present invention, the sealing material composition is preferably cured by heating. The heating temperature during the curing is not limited as long as it is a temperature at which the curable silicone resin composition can be cured. The heating temperature is preferably less than the melting temperature of the outer shells of the particles (B), and when the particles (B) are already expanded, the heating temperature is preferably less than the temperature at which the particles are expanded. Thus, changes in the shape and particle diameter of the particles (B) due to heating during curing are prevented. A specific heating temperature is, for example, 80 to 180°C, and preferably 100 to 160°C.

In addition, it is preferred that the layered sheet-shaped sealing material of the present invention be obtained by providing a sealing material composition that is formed into a sheet shape by the same method as the above on a resin film, and then curing the sealing material composition, and the resin film be adhered to the sheet-shaped sealing material by this curing. The curing is preferably performed by heating at the above-described heating temperature.

Examples of a method for increasing the adhesive strength between a silicone resin foamed body (A) and a film (B) include a method of previously adding a coupling agent to both or either of the sealing material composition and/or the resin film, a method of applying a primer such as a coupling agent to the joining surface between the sealing material composition and the resin film, and a method of disposing a pressure-sensitive adhesive on the joining surface between the sealing material composition and the resin film in a range that does not impair the thickness and properties of the sealing material composition and the resin film.

[Sealing Material for Solar Cell Panel]

The sheet-shaped sealing material of the present invention is used, for example, as a sealing material for solar cell panel. In the sealing material for solar cell panel, the sheet-shaped sealing material may be used alone, but the sealing material for solar cell panel may be the sheet-shaped sealing material having another layer that is provided on one surface or both surfaces thereof as described above, and the layered sheet-shaped sealing material is preferably used.

[Solar Cell Module]

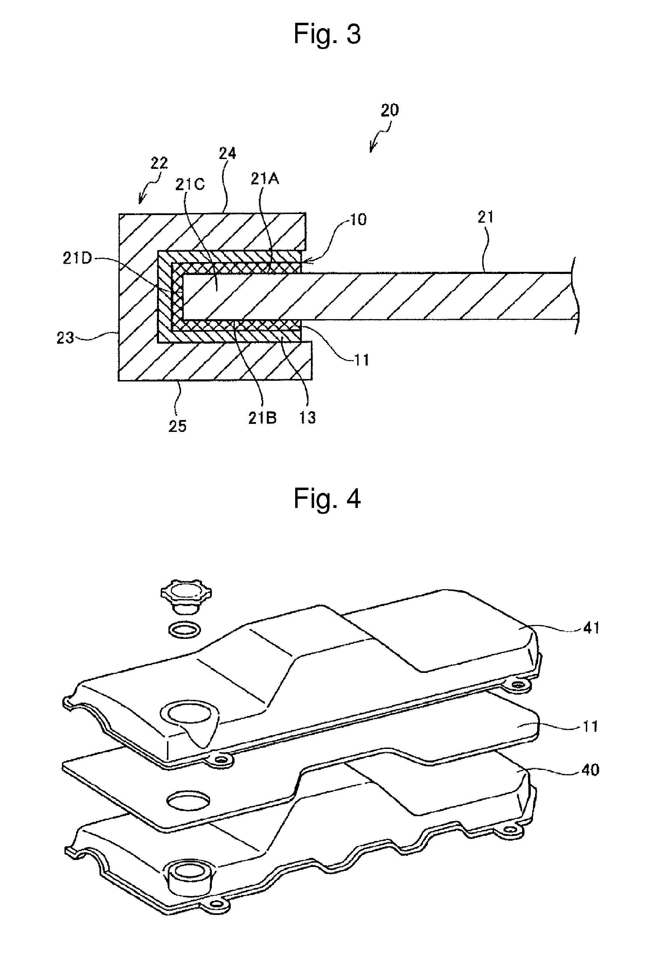

Figures 2 and 3 show a solar cell module using the sealing material for solar cell panel of the present invention.

As shown in Figures 2 and 3, a solar cell module 20 comprises a solar cell panel 21, a frame 22 as a fixing member that fixes a peripheral end portion 21C of the solar cell panel 21, and a sealing material for solar cell panel disposed between the peripheral end portion 21C and the frame 22. This description shows an example of a case where the layered sheet-shaped sealing material 10 in which the resin film 13 is provided on one surface of the sheet-shaped sealing material 11 is used as the sealing material for solar cell panel.

The solar cell panel 21 has a generally rectangular flat plate shape, and known solar cell panels such as crystal-, thin film-, and CI(G)S-based solar cell panels are used. The solar cell panel 21 comprises a power generation layer, a glass substrate (not shown) formed on a light-receiving surface 21A that is for receiving sunlight, and a resin layer (not shown) and a protective layer (not shown) sequentially formed on a back surface 21B (that is opposite to the light-receiving surface), the surfaces 21A and 21B being both surfaces of the power generation layer. In addition, although not shown, a terminal cable (not shown) for taking out electricity from the power generation layer, and a terminal box (not shown) for housing the terminal cable are provided on the back surface 21B of the solar cell panel 21. The thickness of the solar cell panel 21 is, for example, 2 to 10 mm, and preferably 3 to 6 mm.

The frame 22 is provided along the sides of the solar cell panel 21 as shown in Figures 2 and 3. The frame 22 is formed in a cross-sectional generally squared U-shape opening inward and integrally comprises a side wall 23 having a flat plate-shape, a light-receiving side wall 24 having a flat plate-shape and extending inward from the upper portion of the side wall 23, and a back side wall 25 having a flat plate-shape and extending inward from the lower portion of the side wall 23. The frame 22 is formed of, for example, a metal material such as aluminum or a resin material, preferably aluminum. The frame 22 is assembled so that the ends of elongations along the sides of the solar cell panel 21 are joined to each other to form four corners, and form a frame shape in a planar view.

The layered sheet-shaped sealing material (sealing material for solar cell panel) 10 is bent in a cross-sectional generally squared U-shape in contact with a side surface 21D, the light-receiving surface 21A, and the back surface 21B of the panel 21 in the peripheral end portion 21C on each side of the solar cell panel 21. The sealing material 10 for solar cell panel is closely contacted with the peripheral end portion 21C of the solar cell panel 21 and attached to the peripheral end portion 21C so that the surface opposite to the surface on which the resin film 13 of the sealing material 10 for solar cell panel is provided (the sheet-shaped sealing material itself) comes into contact with the surfaces of the peripheral end portion 21C. The resin film 13 is disposed outside (the frame 22 side) in the squared U-shape of the layered sheet-shaped sealing material 10, and the sheet-shaped sealing material 11 is disposed inside (the solar cell panel 21 side).

The inside of the layered sheet-shaped sealing material 10 may be indirectly irradiated with sunlight that is optically guided through the glass or resin of the solar cell panel 21, but since the sheet-shaped sealing material 11 formed of a silicone resin having excellent light resistance is present on the inside, the deterioration of the resin film 13 due to sunlight is prevented, and the durability of the layered sheet-shaped sealing material 10 is good.

In addition, when the sealing material 10 for solar cell panel is attached around the peripheral end portion 21C on the sides of the solar cell panel 21 and returned to the attachment start position, in which a part of the sealing material is overlapped. By this overlapping, the entry of water (including water vapor) from between the ends of the sealing material 10 is prevented. The thickness of the overlapped part is substantially doubled.

The peripheral end portion 21C to which the sealing material 10 for solar cell panel is attached is press-fitted into the squared U-shape of the frame 22 and attached to the frame 22. Thus, the frame 22 further sandwiches the peripheral end portion 21C of the solar cell panel 21 that is sandwiched by the sealing material 10 for solar cell panel, and supports the solar cell panel 21. The sealing material 10 for solar cell panel is compressed and disposed between the light-receiving surface 21A and the light-receiving side wall 24, between the side wall 23 and the side surface 21D, and between the back surface 21B and the back side wall 25 and seals between these.

At this time, the layered sheet-shaped sealing material (sealing material for solar cell panel) 10 is preferably disposed in a state of being compressed at a compressibility of 20 to 50% at 20°C. Due to the individual differences in solar cell panels and frames, variations usually occur in the size of the gap between the panel 21 and the frame 22. In the present invention, by setting the compressibility in this range while setting the compressive stress and expansion ratio of the sheet-shaped sealing material 11 in the above-described ranges, the gap between the solar cell panel 21 and the frame 22 can be sufficiently filled with the layered sheet-shaped sealing material 10 even if variations occur in the size of the gap.

In addition, when the compressibility is in the above range, the intrusion of moisture between the peripheral edge portion 21C of the solar cell panel 21 and the frame 22 can be prevented when it is exposed to wind and rain or it is cleaned by a cleaning machine. In addition, by setting the compressibility to 50% or less, the efficiency of the work of fitting the solar cell panel 21 into the frame 22 is satisfactory.

In this manner, the sealing material 10 for solar cell panel seals the peripheral end portion 21C of the solar cell panel 21 and prevents the entry of water into the solar cell panel 21, for example. In addition, in the present invention, a silicone resin in which a plurality of particles each having a cavity portion are dispersed is used as the sheet-shaped sealing material 11, and therefore, the waterproof performance and shock absorption resistance performance of the sealing material 10 for solar cell panel are enhanced.

In the above description, an example in which a layered sheet-shaped sealing material consisting of two layers, a resin film and a sheet-shaped sealing material, is used as a sealing material for solar cell panel has been described, but the cases where sealing materials for solar cell panel having other configurations are used are same as those. For example, when a pressure-sensitive adhesive layer is provided on the surface opposite to the surface on which the resin film is provided, the configuration is the same as the above-described configuration except that the sealing material 10 for solar cell panel is affixed to the panel by adhering the pressure-sensitive adhesive layer to the peripheral end portion 21C. However, in the present invention, as the sealing material for solar cell panel, a sheet-shaped sealing material in which a plurality of particles each having a cavity portion are dispersed in a silicone resin is used, and therefore, the sealing properties between the frame 22 and the solar cell panel 21 are sufficiently ensured even if no pressure-sensitive adhesive layer is provided.

[Sealing Material for Vehicle]

The sheet-shaped sealing material and layered sheet-shaped sealing material of the present invention are used, for example, as sealing materials for vehicle such as automobiles, motorcycles, and the like. Particularly, automobiles may be used in a wide temperature range such as at high temperature in midsummer and at low temperature in a frigid climate, and therefore, it is required that the sealing materials for vehicle can be used even in severe use environments involving large temperature changes.

The sealing materials for vehicle are used, for example, as various sealing materials for parts used in vehicle power sources such as internal combustion engines (gasoline engines, diesel engines, and the like) and electric motors and high temperature portions around them. The sheet-shaped sealing material 11 is used, for example, as a sealing material that is disposed between an engine main body 40 and an engine cover 41 as shown in Figure 4 and seals between these or seals a fitting portion and the like.

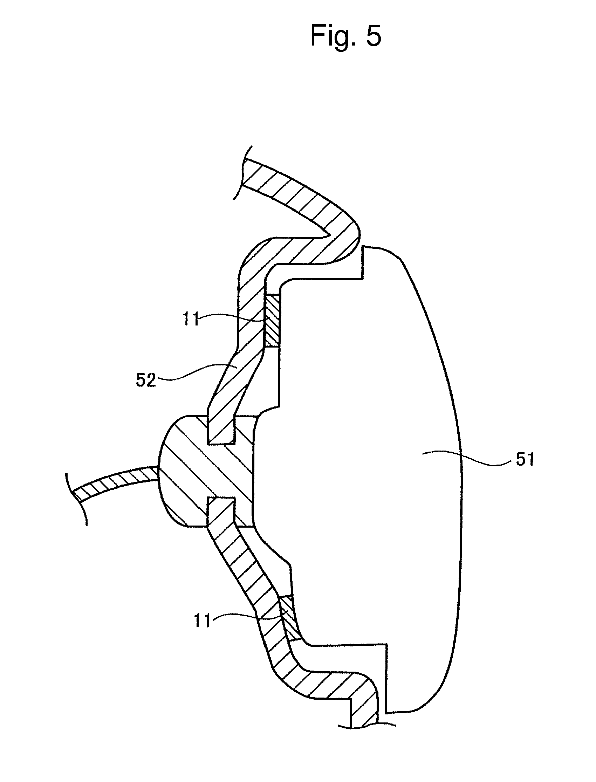

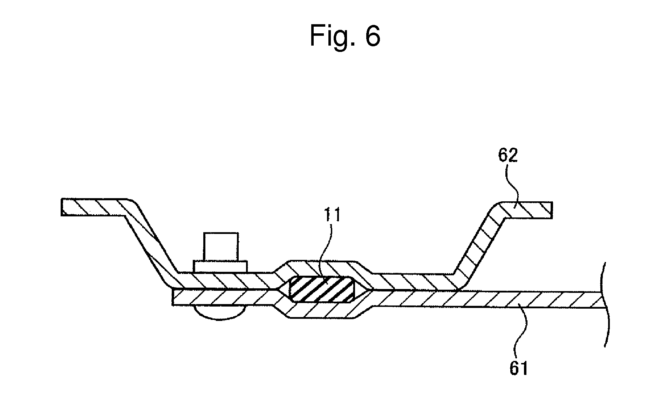

In addition, the sealing materials for vehicle may be used, for example, in the joining sites of unit parts in lamps typified by front and rear lamps, an air conditioner, mirrors, and a sunroof in an automobile or the like, and are used, for example, in order to seal gaps between parts constituting these and gaps occurring between parts constituting these and other unit parts. Specifically, as shown in Figure 5, the sheet-shaped sealing material 11 is disposed between a rear lamp 51 and a holding member 52 for holding the rear lamp 51 and ensures the sealing properties between them. In addition, the sheet-shaped sealing material 11 is disposed between a panel holding member 61 that holds the panel of a sunroof and a bracket 62 that attaches the panel holding member 61 to the car body side, as shown in Figure 6, and ensures the sealing properties between these.

Furthermore, in an automobile exterior panel and dash panel, the sealing materials for vehicle may be used in order to seal gaps occurring in the panels, for example, gaps occurring in these panels themselves, or gaps occurring between these panels and other parts.

In the examples shown in Figures 4 to 6, examples in which the sealing material for vehicle consists the sheet-shaped sealing material 11 alone are shown, but the layered sheet-shaped sealing material can be used.

[Other Applications]

The sheet-shaped sealing material and layered sheet-shaped sealing material of the present invention can also be used in applications other than the above applications and are preferably used particularly in applications used in severe use environments involving large temperature changes. Specifically, the sheet-shaped sealing material and layered sheet-shaped sealing material of the present invention may be used for various sealing materials for parts used in fuel cells, household fuel cell cogeneration systems (common name: ENE-FARM), gas turbines, interior materials in transport means other than vehicles, such as aircraft, and power sources and high temperature portions around them.

Examples

The present invention will be described in more detail using Examples, but the present invention is not limited to these example.

[Measurement Methods]

Properties and performance were evaluated by methods as shown below.

<Average Particle Diameter and Void Ratio>

The average particle diameter and void ratio were calculated by the methods described in this specification using a microscope (manufactured by KEYENCE, model VH-Z series).

<Expansion Start Temperature and Maximum Expansion Temperature>

The expansion start temperature (Ts) and maximum expansion temperature (Tmax) were measured using a thermomechanical analyzer (TMA) (TMA2940, manufactured by TA instruments). Specifically, 25 $\mu$g of a specimen was placed in a container made of aluminum having a diameter of 7 mm and a depth of 1 mm, and heated from 80°C to 220°C at a temperature increase rate of 5°C/min in a state in which a force of 0.1 N was applied from above, and the displacement of the measurement terminal in the vertical direction was measured. The temperature at which the displacement starts to increase was taken as the expansion start temperature, the maximum value of the displacement was taken as the amount of maximum displacement, and the temperature at the amount of maximum displacement was taken as the maximum expansion temperature.

<Thickness>

The thickness was measured by a dial gauge.

<Specific Gravity and Expansion Ratio of Sheet-shaped Sealing Material>

The measurement of the specific gravity of a sheet-shaped sealing material was conducted according to JIS K6767.

In addition, the expansion ratio is obtained by dividing the specific gravity of a sealing material composition by the specific gravity of a sheet-shaped sealing material. However, the sealing material composition at this time is in a state before particles (B) expand.

<Compressive Stress>

The 20% compressive stress of a sheet-shaped sealing material was measured according to JIS K6767. In the present invention, the measurement was conducted with a plurality of sheet-shaped sealing materials piled up so that the total thickness was 10 mm.

<Closed Cell Ratio>

Measurement was conducted by the method described in this specification.

<Tensile Strength and Breaking Elongation>

The tensile strength measurement and the measurement of breaking elongation were conducted according to JIS K6767. The tensile strength and the breaking elongation mean strength and elongation at break. In these Examples, the measurement was conducted using a test piece having a width of 20 mm with the distance between chucks set to 50 mm. In addition, the MD direction was set to the tensile direction. In the case of a layered sheet-shaped sealing material, a sample was made so that the MD directions of the resin film and the sheet-shaped sealing material align.

<Cycle Test>

Ultraviolet irradiation, temperature cycle, and condensation freezing cycle tests were carried out in order on a sheet-shaped sealing material or a layered sheet-shaped sealing material according to IEC61215. Specifically, the state after 15 kWh·m$^{-2}$ ultraviolet irradiation by an ultraviolet pretreatment test followed by a temperature cycle test [-40 to 85°C x 50 cycles] further followed by a condensation freezing cycle test [-40 to 85°C x 85% RH x 10 cycles] was observed. For one with no change in state, "Good" was described in a table. For one with a change in state, the state change was described in the table.

<Ultraviolet Irradiation Test>

The ultraviolet irradiation test for a resin film used in a layered sheet-shaped sealing material was carried out according to UL746C. Specifically, breaking elongation after irradiation at a black panel (BP) temperature of 63°C for 1,000 hours was measured.

<Compression Set>

The compression set of a sheet-shaped sealing material or a layered sheet-shaped sealing material was measured according to JIS K 6767. In the present invention, a plurality of sheet-shaped sealing materials or layered sheet-shaped sealing materials were piled up so that the total thickness was 10 mm and the conditions were a temperature of 70°C and a compressibility of 50%, that is, strain to a thickness of 5 mm. Except for these, the measurement was conducted according to JIS.

<Dielectric Breakdown Voltage>

The dielectric breakdown voltage was measured according to IEC 60243-1.

<Moisture Permeability>

The moisture permeability was measured according to JIS Z 0208.

[Example 1]

(Making of Particles (B))

5 Parts by weight of thermally-expandable microcapsules (average particle diameter 16 $\mu$m, spherical, expansion start temperature 122°C, maximum expansion temperature 167°C, "ADVANCELL EML101" manufactured by SEKISUI CHEMICAL CO., LTD.) and 10 parts by weight of "TSE3032A" (viscosity (23°C) : 4.2 Pa·s), which was the base resin for a silicone resin (two-component heat-curable liquid silicone rubber) manufactured by Momentive Performance Materials Japan LLC., were mixed to be uniform to obtain a mixture. Then, the mixture was placed on a PET film and heated at 155°C for 4 minutes to expand the thermally-expandable microcapsules to obtain a mixture containing particles (B) each having a cavity portion therein.

(Making of Sealing Material Composition)

Next, 2.1 parts by weight of the mixture containing the particles (B) obtained above, 10.6 parts by weight of "TSE3032A," which was the base resin for a silicone resin manufactured by Momentive Performance Materials Japan LLC., and 1.2 parts by weight of "TSE3032B" (viscosity (23°C) : 0.7 Pa·s), which was the curing agent for the silicone resin, were mixed at ordinary temperature (23°C) to obtain a sheet-shaped sealing material composition.

(Making of Sheet-shaped Sealing Material)

The sealing material composition was quantitatively and continuously fed between two rolls with a clearance of 0.6 mm and spread between two PET films (manufactured by Toray Industries Inc., Lumirror S10, thickness 0.05 mm), and continuously heated at 120°C for 5 minutes. At this point, it was considered that the curing reaction was not completed, but the heating was stopped because no problems would occur in subsequent handling. After being allowed to stand at ordinary temperature (23°C) for 1 day, both PET films were peeled to obtain a sheet-shaped sealing material. Its thickness and specific gravity were measured to be 0.5 mm and 0.21 g/cc, respectively.
In addition, in the sheet-shaped sealing material, the average particle diameter of the particles (B) was 80 $\mu$m, which was 5 times that of the thermally-expandable microcapsules before foaming. In addition, the void ratio of the particles (B) was 90.1%.

[Example 2]

(Making of Particles (B))

5.5 Parts by weight of thermally-expandable microcapsules (average particle diameter 16 $\mu$m, spherical, expansion start temperature 122°C, maximum expansion temperature 167°C, "ADVANCELL EML101" manufactured by SEKISUI CHEMICAL CO., LTD.) and 15 parts by weight of "TSE3032A" (viscosity (23°C) : 4.2 Pa·s), which was the base resin for a silicone resin (two-component heat-curable liquid silicone rubber) manufactured by Momentive Performance Materials Japan LLC., were mixed to be uniform to obtain a mixture. Then, the mixture was placed on a PET film and heated at 155°C for 4 minutes to expand the thermally-expandable microcapsules to obtain a mixture containing particles (B) each having a cavity portion therein.

(Making of Sealing Material Composition)

Next, 2.6 parts by weight of the mixture containing the particles (B) obtained above, 10.1 parts by weight of "TSE3032A," which was the base resin for a silicone resin manufactured by Momentive Performance Materials Japan LLC., and 1.2 parts by weight of "TSE3032B" (viscosity (23°C) : 0.7 Pa·s), which was the curing agent for the silicone resin, were mixed at ordinary temperature (23°C) to obtain a sheet-shaped sealing material composition.

(Making of Sheet-shaped Sealing Material)

The sealing material composition was quantitatively and continuously fed between two rolls with a clearance of 0.2 mm and spread between PET films (manufactured by Toray Industries Inc., Lumirror S10, thickness 0.05 mm), and continuously heated at 155°C for 4 minutes. At this point, it was considered that the curing reaction was not completed, but the heating was stopped because no problems would occur in subsequent handling. After being allowed to stand at ordinary temperature for 1 day, both PET films were peeled to obtain a sheet-shaped sealing material. For this sheet-shaped sealing material, the thickness and specific gravity were measured to be 0.1 mm and 0.39 g/cc, respectively. Furthermore, tests of which results are shown in Table 1 were also carried out. In the sheet-shaped sealing material, the average particle diameter of the particles (B) was 45 $\mu$m, which was 2.8 times that of the thermally-expandable microcapsules before foaming. In addition, the void ratio of the particles (B) was 92.0%.

[Example 3]

(Making of Particles (B))

5 Parts by weight of thermally-expandable microcapsules (average particle diameter 40 $\mu$m, spherical, expan-

sion start temperature 118°C, maximum expansion temperature 172°C, "ADVANCELL EMH204" manufactured by SEKISUI CHEMICAL CO., LTD.) and 10 parts by weight of "TSE3032A" (viscosity (23°C) : 4.2 Pa·s), which was the base resin for a silicone resin (two-component heat-curable liquid silicone rubber) manufactured by Momentive Performance Materials Japan LLC., were mixed to be uniform to obtain a mixture. Then, the mixture was placed on a PET film and heated at 160°C for 5 minutes to expand the thermally-expandable microcapsules to obtain a mixture containing particles (B) each having a cavity portion therein.

(Making of Sealing Material Composition)

Next, 2.1 parts by weight of the mixture containing the particles (B) obtained above, 10.6 parts by weight of "TSE3032A," which was the base resin for a silicone resin manufactured by Momentive Performance Materials Japan LLC., and 1.2 parts by weight of "TSE3032B" (viscosity (23°C) : 0.7 Pa·s), which was the curing agent for the silicone resin, were mixed at ordinary temperature (23°C) to obtain a sealing material composition.

(Making of Layered Sheet-shaped Sealing Material)

The sealing material composition was quantitatively and continuously fed between two rolls with a clearance of 1.97 mm and spread between a PET film (manufactured by Toray Industries Inc., Lumirror S10, thickness 0.05 mm) on one side and a polyethylene film (manufactured by SEKISUI FILM CO., LTD., product name: Bejitaron Super Kirinashi, thickness 0.12 mm, moisture permeability 15 g/m$^2$·day, breaking elongation (before UV exposure) 200% or more, breaking elongation after 1000 hours of the UV exposure test prescribed in UL746C: 200% or more) on the opposite side, and continuously heated at 120°C for 5 minutes. At this point, it was considered that the curing reaction was not completed, but the heating was stopped because no problems would occur in subsequent handling. After being allowed to stand at ordinary temperature for 1 day, only the PET film on one side was peeled to obtain a layered sheet-shaped sealing material in which the polyethylene film was provided on a sheet-shaped sealing material. For this layered sheet-shaped sealing material, the cycle test, the ultraviolet irradiation test, and the tests of compression set and moisture permeability were conducted. The results are shown in Table 1. In the layered sheet-shaped sealing material, the average particle diameter of the particles (B) was 150 μm, which was 3.75 times that of the thermally-expandable microcapsules before foaming. In addition, the void ratio of the particles (B) was 94.9%.

(Making of Sheet-shaped Sealing Material)

In addition, in order to measure the thickness and specific gravity of the sheet-shaped sealing material in the layered sheet-shaped sealing material in Example 3, operation was carried out same as in the making of the layered sheet-shaped sealing material except that the sealing material composition was spread between two PET films instead of being spread between the PET film and the polyethylene film, and both the two PET films were peeled instead of peeling only the PET film on one side, to make a sheet-shaped sealing material. The thickness and specific gravity of the sheet-shaped sealing material were measured to be 1.8 mm and 0.14 g/cc, respectively.

[Example 4]

(Making of Layered Sheet-shaped Sealing Material)

As a resin film, a polyethylene film (manufactured by SEKISUI FILM CO., LTD., product name: Bejitaron Super Kirinashi, thickness 0.12 mm, moisture permeability 15 g/m$^2$·day, breaking elongation (before UV exposure) 200% or more, breaking elongation after 1000 hours of the UV exposure test prescribed in UL746C: 200% or more) was prepared. In addition, a stainless plate having a thickness of 3 mm and a quadrangular frame member having a thickness of 0.5 mm and having an opening 18 cm long x 18 cm wide were prepared. The opening of the frame member was filled with 10 g of the sheet-shaped sealing material composition same as Example 1. The stainless plate and the above polyethylene film were disposed on one surface side of the frame member, and the stainless plate and a PET film (manufactured by Teijin DuPont Corp., product name Teijin Tetoron Film HB, thickness 50 μm) were disposed on the opposite surface side. The frame member with the sealing material composition was heated at a pressure of 10 MPa and 145°C for 20 minutes by a pressing machine to cure the sealing material composition. After the curing, the PET film was peeled to obtain a layered sheet-shaped sealing material consisting of a sheet-shaped sealing material in which closed cells were formed by the cavity portions of particles (C) and the polyethylene film. In the layered sheet-shaped sealing material, the average particle diameter and void ratio of the particles (B) were 77 μm and 86.8%, respectively. The sheet-shaped sealing material composition that had been spilled over from the frame member during the pressing was removed. In addition, for the evaluation of the sheet-shaped sealing material alone, a sheet-shaped sealing material without a film was made similar to those in Example 3.

[Example 5]

The layered sheet-shaped sealing material of Example 5 was obtained as in Example 4 except that the resin film was a polyethylene film (manufactured by SEKISUI FILM CO., LTD., product name: HANAYAKA Kyojin UV Long, thickness 0.17 mm, moisture permeability 14 g/m$^2$·day, breaking elongation (before the UV exposure test): 200% or more, breaking elongation after 1000 hours of the UV exposure test prescribed in UL746C: 200% or more). For the evaluation of the sheet-shaped sealing material alone, a sheet-shaped sealing material without a film was made similar to those in Example 3. In the layered sheet-shaped sealing material, the average particle diameter and void ratio of the particles (B) were 77 $\mu$m and 86.8%, respectively.

[Example 6]

(Making of Sheet-shaped Sealing Material)

A stainless plate having a thickness of 3 mm and a quadrangular frame member having a thickness of 2.3 mm and having an opening 18 cm long x 18 cm wide were prepared. In order to measure the thickness and specific gravity of a sheet-shaped sealing material, the opening of the frame member was filled with 13 g of the sheet-shaped sealing material composition same as that in Example 1. The stainless plate and a PET film (manufactured by Teijin DuPont Corp., product name Teijin Tetoron Film HB, thickness 50 $\mu$m) were disposed on both surface sides of the frame member. The frame member with the sealing material composition was heated at a pressure of 0.1 MPa and 145°C for 20 minutes by a pressing machine to cure the sealing material composition. After the curing, the PET films were peeled to obtain a sheet-shaped sealing material.

(Making of Layered Sheet-shaped Sealing Material)

A layered sheet-shaped sealing material was obtained same as in the making of the above sheet-shaped sealing material except that the PET film on one surface side was changed to "OT film" manufactured by SEKISUI CHEMICAL CO., LTD, 0.5 $\mu$m "XP80-A5363" manufactured by Momentive was previously applied to a surface of the film, and the sealing material composition was brought into contact with this surface.

[Example 7]

A sheet-shaped sealing material and a layered sheet-shaped sealing material were obtained same as in Example 6 except that the thickness of the quadrangular frame member having an opening was 0.7 mm, the sheet-shaped sealing material composition same as Example 1 that filled therein was 4 g, the resin film was "PBT film" manufactured by Kansai Chemicals Co., Ltd., 0.5 $\mu$m "XP80-A5363" manufactured by Momentive was previously applied to a surface of the film, and the sealing material composition was brought into contact with this surface.

[Example 8]

A layered sheet-shaped sealing material was made by a method for making a layered sheet-shaped sealing material same as that in Example 3 using a sheet-shaped sealing material composition same as that in Example 1. However, the roll clearance was set to 0.21 mm. In addition, the resin film used was "MAXBARRIER" manufactured by Mitsui Chemicals Tohcello, Inc. instead, 0.5 $\mu$m "XP80-A5363" manufactured by Momentive was previously applied to a surface of the film and the sealing material composition was spread on this surface.
In order to measure the thickness and specific gravity of the sheet-shaped sealing material, a sheet-shaped sealing material was made by a method for making a sheet-shaped sealing material same as that in Example 3.

[Example 9]

A layered sheet-shaped sealing material was made same as those in Example 8 except that the roll clearance was set to 0.13 mm, the resin film used was "Soarnol AT4403" (ethylene content 44 mol%) manufactured by The Nippon Synthetic Chemical Industry Co., Ltd., and "XP80-A5363" manufactured by Momentive was not previously applied to a surface of the films.

[Example 10]

A layered sheet-shaped sealing material was made same as those in Example 8 except that the roll clearance was set to 1.15 mm, and the resin film used was "Soarnol AT4403" (ethylene content 44 mol%) manufactured by The Nippon Synthetic Chemical Industry Co., Ltd.

[Comparative Example 1]

As the sheet-shaped sealing material of Comparative Example 1, the acrylic foam having a thickness of 0.8 mm "PB80, manufactured by 3M" was used.

[Comparative Example 2]

A silicone sealant (manufactured by Dow Corning Toray Co., Ltd., SH780) was poured into a mold having a depth of 0.5 mm to make a sheet-shaped sealing material having a thickness of 0.5 mm.

[Comparative Example 3]

(Making of Sealing Material Composition)

In order to measure the thickness and specific gravity of a sheet-shaped sealing material, 100 parts by weight of TOSFOAM 5700(A), which was the base resin for a silicone resin manufactured by Momentive Performance Materials Japan LLC., and 12 parts by weight of TOSFOAM 5700(B), which was the curing agent for the silicone resin, were uniformly mixed, and the mixture was quantitatively and continuously fed between two rolls with a clearance of 0.6 mm and spread between two PET films (manufactured by Toray Industries Inc., Lumirror S10, thickness 0.05 mm), and continuously heated at 50°C for 2 minutes to be cured while being foamed. At this point, it was considered that the curing reaction was not completed, but the heating was stopped because no problems would occur in subsequent handling. Immediately afterward, the two PET films were peeled to obtain a sheet-shaped sealing material. After the sheet-shaped sealing material was allowed to stand at ordinary temperature for 1 day, its thickness and specific gravity were measured to be 3.3 mm and 0.17 g/cc, respectively.

(Making of Layered Sheet-shaped Sealing Material)

A layered sheet-shaped sealing material was made same as in the above making of the sealing material composition except that one of the PET films was changed to a film same as that in Example 3.

[Comparative Example 4]

10 Parts by weight of the base resin for a silicone resin (TSE3032A) and 1 part by weight of the curing agent for the silicone resin (TSE3032B) were uniformly mixed, and the mixture was quantitatively and continuously fed between two rolls with a clearance of 0.4 mm and spread between two PET films (manufactured by Toray Industries Inc., Lumirror S10, thickness 0.05 mm), and continuously heated at 50°C for 2 minutes. At this point, it was considered that the curing reaction was not completed, but the heating was stopped because no problems would occur in subsequent handling. Immediately afterward, both the two PET films were peeled to obtain a sheet-shaped sealing material. After the sheet-shaped sealing material was allowed to stand at ordinary temperature for 1 day, the thickness and specific gravity were measured to be 0.3 mm and 1.1 g/cc, respectively.

The conditions of the Examples and the Comparative Examples are summarized in Table 1.

[Table 1]

Table 1-1

| | | Example 1 | Example 2 | Example 3 | Example 4 | Example 5 | Example 6 | Example 7 |
|---|---|---|---|---|---|---|---|---|
| Type | | Sheet-shaped sealing material | Sheet-shaped sealing material | Layered sheet-shaped sealing material | Layered sheet-shaped sealing material | Layered sheet-shaped sealing material | Layered sheet-shaped sealing material | Layered sheet-shaped sealing material |
| Resin film | Resin film type | - | - | PE | PE | PE | PBT | PBT |
| | Resin film name | - | - | Bejitaron Super Kirinashi | Bejitaron Super Kirinashi | HANAYAKA Kyojin UV Long | OT film | PBT film |
| | Primer | - | - | - | - | - | XP80-A5363 | XP80-A5363 |
| Making of particles (B) | Thermally-expandable microcapsules parts by weight | ADVANCELL EML101　5 | ADVANCELL EML101　5.5 | ADVANCELL EMH204　5 | ADVANCELL EML101　5 | ADVANCELL EML101　5 | ADVANCELL EML101　5 | ADVANCELL EML101　5 |
| | Base resin parts by weight | TSE3032A　10 | TSE3032A　15 | TSE3032A　10 | TSE3032A　10 | TSE3032A　10 | TSE3032A　10 | TSE3032A　10 |
| Making of sealing material composition | Mixture containing particles (B) parts by weight | 2.1 | 2.6 | 2.1 | 2.1 | 2.1 | 2.1 | 2.1 |
| | Base resin parts by weight | TSE3032A　10.6 | TSE3032A　10.1 | TSE3032A　10.6 | TSE3032A　10.6 | TSE3032A　10.6 | TSE3032A　10.6 | TSE3032A　10.6 |
| | Curing agent parts by weight | TSE3032B　1.2 | TSE3032B　1.2 | TSE3032B　1.2 | TSE3032B　1.2 | TSE3032B　1.2 | TSE3032B　1.2 | TSE3032B　1.2 |

Table 1-2

| Type | | | Example 8 | Example 9 | Example 10 | Comparative Example 1 | Comparative Example 2 | Comparative Example 3 | Comparative Example 4 |
|---|---|---|---|---|---|---|---|---|---|
| | | | Layered sheet-shaped material | Layered sheet-shaped material | Layered sheet-shaped material | Acrylic foam | Silicone sealant | Layered sheet-shaped material | Non-foamed sheet |
| Resin film | Resin film type | | PET | EVOH | EVOH | - | - | PE | - |
| | Resin film name | | MAXBARRIER | Soarnol AT4403 | Soarnol AT4403 | - | - | Bejitaron Super Kirinashi | - |
| | Primer | | XP80-A5363 | - | XP80-A5363 | - | - | - | - |
| Making of particles (B) | Thermally-expandable microcapsules | | ADVANCELL EML101 | ADVANCELL EML101 | ADVANCELL EML101 | - | - | - | - |
| | | parts by weight | 5 | 5 | 5 | - | - | - | - |
| | Base resin | | TSE3032A | TSE3032A | TSE3032A | - | - | - | - |
| | | parts by weight | 10 | 10 | 10 | - | - | - | - |
| | Mixture containing particles (B) | | | | | | | | |
| | | parts by weight | 2.1 | 2.1 | 2.1 | - | - | - | - |
| Making of sealing material composition | Base resin | | TSE3032A | TSE3032A | TSE3032A | - | - | TOSFOAM 5700(A) | TSE3032A |
| | | parts by weight | 10.6 | 10.6 | 10.6 | - | - | 100 | 10 |
| | Curing agent | | TSE3032B | TSE3032B | TSE3032B | - | - | TOSFOAM 5700(B) | TSE3032B |
| | | parts by weight | 1.2 | 1.2 | 1.2 | - | - | 12 | 1 |

22

The measurement results and evaluation results of the members in the Examples and the Comparative Examples are shown in Table 2.
[Table 2]

Table 2

| | | Example 1 | Example 2 | Example 3 | Example 4 | Example 5 | Example 6 | Example 7 | Example 8 | Example 9 | Example 10 | Comparative Example 1 | Comparative Example 2 | Comparative Example 3 | Comparative Example 4 |
|---|---|---|---|---|---|---|---|---|---|---|---|---|---|---|---|
| Sheet-shaped sealing material | Thickness (mm) | 0.5 | 0.1 | 1.8 | 0.5 | 0.5 | 2.3 | 0.7 | 0.15 | 0.07 | 0.9 | 0.8 | 0.5 | 3.3 | 0.3 |
| | Specific gravity (g/cc) | 0.21 | 0.39 | 0.14 | 0.47 | 0.47 | 0.16 | 0.18 | 0.21 | 0.21 | 0.21 | 1.4 | 1.0 | 0.17 | 1.1 |
| | Expansion ratio (times) | 5.2 | 2.8 | 7.8 | 2.3 | 2.3 | 7 | 6 | 5.2 | 5.2 | 5.2 | - | - | 7.0 | - |
| | Closed cell ratio (%) | 100 | 100 | 100 | 100 | 100 | 75 | 85 | 100 | 100 | 100 | - | - | 3 | - |
| | 20% Compressive stress (MPa) | 0.09 | 0.13 | 0.06 | 0.5 | 0.5 | 0.06 | 0.07 | 0.09 | 0.09 | 0.09 | 0.01 | 55 | 0.005 | 37 |
| | 5% Elongation tension [a] (N/m) | - | - | 162 | 110 | 110 | 207 | 71 | 18 | 8 | 108 | - | - | 40 | - |
| Average particle diameter of Particles (B) (μm) | | 80 | 45 | 150 | 77 | 77 | 80 | 80 | 80 | 80 | 80 | - | - | - | - |

| | | Example 1 | Example 2 | Example 3 | Example 4 | Example 5 | Example 6 | Example 7 | Example 8 | Example 9 | Example 10 | Comparative Example 1 | Comparative Example 2 | Comparative Example 3 | Comparative Example 4 |
|---|---|---|---|---|---|---|---|---|---|---|---|---|---|---|---|
| Resin film | Moisture Permeability (g/m$^2$/day) | - | - | 15 | 15 | 14 | 25 | 27 | 0.3 | 24 | 4 | - | - | 15 | - |
| | Thickness (mm) | - | - | 0.12 | 0.12 | 0.17 | 0.05 | 0.025 | 0.012 | 0.012 | 0.2 | - | - | 0.12 | - |
| | Ultraviolet irradiation test (%) | - | - | 200 or more | 200 or more | 200 or more | 110 | 220 | 95 | 120 | 135 | - | - | 200 or more | - |
| | Type of resin | | - | PE | PE | PE | PBT | PBT | PET | EVOH | EVOH | - | - | PE | - |
| | 5% Elongation tension [b] (N/m) | - | - | 383 | 383 | 454 | 502 | 217 | 49 | 38 | 643 | - | - | 383 | - |
| a/b (%) | | - | - | 42% | 29% | 24% | 41% | 33% | 37% | 21% | 17% | - | - | 10% | - |
| Sealing material evaluation | Cycle test (%) | Good | Good | Good | Good | Good | Good | Good | Good | Good | Good | Cured | Good | Good | Good |
| | Compression set (%) | 10 | 13 | 4 | 12 | 12 | 3 | 7 | 10 | 10 | 10 | 33 | 2 | 1.5 | 1 |
| | Moisture Permeability (g/m$^2$/day) | 130 | 172 | 7 | 12 | 8 | 22 | 22 | 0.3 | 21 | 3 | 10 | 156 | 530 | 230 |

\* In Table 2. the "Sheet-shaped sealing material" column shows the results of measurement for the sheet-shaped sealing materials, and the "Resin films" column shows the results of measurement for the resin films.

In addition, the " Sealing material evaluation" column shows the results of measurement for the sheet-shaped sealing materials for Examples 1 and 2 and Comparative Examples 1. 2. and 4 and shows the results of measurement for the layered sheet-shaped sealing materials in Examples 3 to 10 and Comparative Example 3.

EP 2 853 574 A1

25

In Examples 1 to 10, the various test results were good, and Examples 1 to 10 was able to be sufficiently used as sealing material for solar cell panel.

In Comparative Example 1, due to ultraviolet irradiation, the strength decreases and shrinkage and curing occur, and Comparative Example 1 cannot function sufficiently as a sealing material for solar cell panel. In addition, the compression set was high, and therefore, the cushioning performance also decreased. On the other hand, in Comparative Examples 2 and 4, the sealing properties are insufficient with no foamed particles blended, and the moisture permeability increases, and it is presumed that when Comparative Examples 2 and 4 are used as sealing material for solar cell panel, water vapor is allowed to pass into solar cell panel. In addition, in Comparative Example 3, the compression set was good, but the moisture permeability was high, and Comparative Example 3 was unsuitable as a sealing material for solar cell panel.

Reference Signs List

10  Layered sheet-shaped sealing material (Sealing material for solar cell panel)
11  Sheet-shaped sealing material
13  Resin film
20  Solar cell module
21  Solar cell panel (object to be attached)
22  Frame (fixing member)

**Claims**

1. A sheet-shaped sealing material comprising: a silicone resin (A); and a plurality of particles (B) dispersed in the silicone resin (A) and each having a cavity portion therein.

2. The sheet-shaped sealing material according to claim 1, having a thickness of 0.05 to 2.5 mm and an expansion ratio of 2 to 8 times.

3. The sheet-shaped sealing material according to claim 1 or 2, wherein the plurality of particles (B) comprise expanded foamed particles and have an average particle diameter of 40 to 200 $\mu$m.

4. The sheet-shaped sealing material according to any of claims 1 to 3, being a sealing material for solar cell panel.

5. A layered sheet-shaped sealing material comprising: the sheet-shaped sealing material according to any of claims 1 to 4; and a resin film provided on one surface of the sheet-shaped sealing material.

6. The layered sheet-shaped sealing material according to claim 5, wherein the sheet-shaped sealing material has a closed cell ratio of 70% or more, and a 20% compressive stress at 20°C of the sheet-shaped sealing material is 0.05 to 0.7 MPa.

7. The layered sheet-shaped sealing material according to claim 5 or 6, wherein a moisture permeability of the resin film in a water vapor moisture permeability test prescribed in JIS Z 0208 is 30 g/m$^2$·day or less, and a thickness of the resin film is 0.01 to 0.25 mm.

8. The layered sheet-shaped sealing material according to any of claims 5 to 7, wherein a breaking elongation of the resin film after a lapse of 1000 hours under UV exposure test conditions prescribed in UL746C is 70% or more.

9. The layered sheet-shaped sealing material according to any of claims 5 to 8, wherein the resin film is an olefin-based resin film, a polyester-based resin film, or an ethylene-vinyl alcohol copolymer-based resin film.

10. The layered sheet-shaped sealing material according to any of claims 5 to 9, wherein a tension at 5% extension of the sheet-shaped sealing material is 15 to 50% of a tension at 5% extension of the resin film.

11. The layered sheet-shaped sealing material according to any of claims 5 to 10, being a sealing material for solar cell panel.

12. A solar cell module comprising: a solar cell panel; a fixing member that fixes a peripheral end portion of the solar cell panel; and the sealing material for solar cell panel according to claim 4 or 11 that is disposed between the fixing member and the solar cell panel.

13. The solar cell module according to claim 12, wherein the sealing material for solar cell panel comprises the layered sheet-shaped sealing material, and the sheet-shaped sealing material is disposed on a solar cell panel side in the layered sheet-shaped sealing material.

14. A method for manufacturing a sheet-shaped sealing material, comprising: curing a sealing material composition comprising a curable silicone resin composition and a plurality of particles each having a cavity portion therein to obtain a sheet-shaped sealing material having cells formed by the cavity portions of the particles.

15. The method for manufacturing a sheet-shaped sealing material according to claim 14, comprising: heating and foaming a plurality of particles having foamability to obtain a plurality of foamed particles each having a cavity portion therein; and mixing the foamed particles and the curable silicone resin composition to obtain the sealing material composition.

16. The method for manufacturing a sheet-shaped sealing material according to claim 14 or 15, comprising steps of:

mixing a part of a base resin of the curable silicone resin composition and a plurality of particles having foamability, and then heating and expanding the particles having foamability to form foamed particles each having a cavity portion therein to obtain a mixture comprising a plurality of the foamed particles and the part of the base resin of the curable silicone resin composition;
blending at least a remainder of the base resin and a curing agent of the curable silicone resin composition into the mixture to obtain a sealing material composition; and
heating and curing the sealing material composition formed into a sheet shape to obtain the sheet-shaped sealing material.

17. A method for manufacturing a layered sheet-shaped sealing material, comprising: curing a sealing material composition that comprises a curable silicone resin composition and a plurality of particles each having a cavity portion therein and that is provided on a resin film to obtain a layered sheet-shaped sealing material having the resin film provided on one surface of a sheet-shaped sealing material having cells formed by the cavity portions of the particles.

# Fig. 1

# Fig. 2

# Fig. 3

# Fig. 4

# Fig. 5

Fig. 6

<div align="center">

**INTERNATIONAL SEARCH REPORT**

</div>

| | International application No. |
|---|---|
| | PCT/JP2013/064216 |

**A. CLASSIFICATION OF SUBJECT MATTER**
*C09K3/10*(2006.01)i, *B32B27/00*(2006.01)i, *B32B27/20*(2006.01)i, *C08J5/18*(2006.01)i, *C08J9/32*(2006.01)i, *C08K7/22*(2006.01)i, *C08L83/05*(2006.01)i, *C08L83/07*(2006.01)i, *H01L31/042*(2006.01)i

According to International Patent Classification (IPC) or to both national classification and IPC

**B. FIELDS SEARCHED**

Minimum documentation searched (classification system followed by classification symbols)
C09K3/10, C08J9/32, C08K7/22, C08L83/05, C08L83/07, H01L31/042

Documentation searched other than minimum documentation to the extent that such documents are included in the fields searched
Jitsuyo Shinan Koho          1922-1996   Jitsuyo Shinan Toroku Koho   1996-2013
Kokai Jitsuyo Shinan Koho    1971-2013   Toroku Jitsuyo Shinan Koho   1994-2013

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>A | JP 2002-012696 A  (Shin-Etsu Chemical Co., Ltd.),<br>15 January 2002 (15.01.2002),<br>claims 1 to 11; paragraphs [0001], [0005] to [0038]; examples<br>& US 2002/0014712 A1   & TW 574094 B | 1-3,14<br>4-13,15-17 |
| A | JP 2003-049156 A  (Bridgestone Corp.),<br>21 February 2003 (21.02.2003),<br>claims 1 to 10<br>(Family: none) | 1-17 |
| A | JP 59-133280 A  (Adachi New Industrial Co., Ltd.),<br>31 July 1984 (31.07.1984),<br>claims 1 to 4<br>(Family: none) | 1-17 |

☐ Further documents are listed in the continuation of Box C.      ☐ See patent family annex.

| | |
|---|---|
| *   Special categories of cited documents:<br>"A"  document defining the general state of the art which is not considered   to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after  the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search<br>09 August, 2013 (09.08.13) | Date of mailing of the international search report<br>20 August, 2013 (20.08.13) |
|---|---|
| Name and mailing address of the ISA/<br>    Japanese Patent Office | Authorized officer |
| Facsimile No. | Telephone No. |

Form PCT/ISA/210 (second sheet) (July 2009)

**EP 2 853 574 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2009071233 A
- JP 2012001707 A
- JP 2000226909 A
- DE 102009011164
- JP 3274071 B
- JP 4114050 B